# EUROPEAN PATENT SPECIFICATION

(11) **EP 4 662 497 B1**
(45) Date of publication and mention of the grant of the patent: **07.10.2026**
(21) Application number: 24712598.2
(22) Date of filing: 02.02.2024
(51) Int. Cl.: G01R 31/58, G01R 19/15, G01R 19/155, G01R 35/00

(54) **DEVICE FOR DETECTING THE VOLTAGE AND/OR THE CURRENT IN AN ELECTRICAL SYSTEM**
VORRICHTUNG ZUR ERFASSUNG DER SPANNUNG UND/ODER DES STROMS IN EINEM ELEKTRISCHEN SYSTEM
DISPOSITIF DE DÉTECTION DE TENSION ET/OU DE COURANT DANS UN SYSTÈME ÉLECTRIQUE

(30) Priority: 10.02.2023 IT 202300002316
(43) Date of publication of application: 17.12.2025
(73) Proprietor: Terna S.p.A., 00156 Roma (IT)
(72) Inventor: GUTTUSO, Antonio, 00156 ROMA (RM) (IT); TERMINI, Cristian, 00156 ROMA (RM) (IT); PICONE, Ferdinando, 00156 ROMA (RM) (IT); MAZZOLA, Bruno, 00156 ROMA (RM) (IT)
(74) Representative: Tiburzi, Andrea
(86) International application number: PCT/IT2024/050027
(87) International publication number: WO 2024/166140

(56) References cited:
- EP-A1- 3 081 947
- EP-A1- 3 567 394
- US-A1- 2013 257 414
- US-A1- 2015 123 674

## Description

The present invention concerns a device for detecting voltage and/or current in an electrical system.

### Field of invention

More in detail, the invention concerns a device designed and realized in particular to allow grounding operations for substations and power lines to be carried out safely, using a mobile and portable instrument comprising means for detecting and revealing the presence of electromagnetic fields. and/or magnetic, which can be connected to the grounding insulation equipment.

### Prior art

Electrical stalls and substations are components of the electricity transmission network located near a production plant, at the delivery points to the end user, and at the interconnection nodes between lines.

More specifically, electrical substations include a series of electrical equipment, such as, for example, switches, transformers, arresters, and the like, connected by conductors configured to convey electrical energy.

Electrical equipment generally requires periodic checks and maintenance to ensure their correct operation. For example, measurement transformers (CT, VT) must be periodically checked as they are subject to measurement errors due to wear and aging.

As is well known, currently, during the verification and maintenance operations of substations and electrical lines, to prevent an operator from being in contact with potentially live parts, for example for maintenance work, it is first necessary to detect whether said parts are subject to voltage, and possibly, before starting any maintenance activity, they must be electrically connected to the grounding circuit. This is generally done by means of appropriate copper wires, i.e., cables of suitable cross-section, capable of withstanding fault and short-circuit currents.

In this way, it is possible to ensure that the part of the system on which it is necessary to operate, being connected to earth, limits, as far as possible, the circulating currents and avoids the creation of dangerous voltages for the operator.

To connect the grounding ropes, well-defined procedures and prescriptions are adopted, such as to minimize the risk of oversights and errors on the part of the operators themselves.

More specifically, currently to operate safely on a part of the plant, certain operational steps must be carried out.

A preliminary step involves the use of a specific voltage detector/detector device, which can be associated with a rod, also known as a "foil", for checking any voltage present on the part of the system, line, equipment etc., which is necessary connected to earth via copper wires to perform maintenance.

This detector device is not put into direct contact with the part of the system to be tested, but reveals the presence of voltage by placing it at a certain distance from it, as prescribed e.g. by CEI 11-27 and CEI 11-15 regulations.

If the part of the system is live, the detector device would warn the operator by issuing an audible and visual warning. In this case the operator would be obliged to interrupt all subsequent operational activities. Furthermore, before continuing, the operator should ensure, through the various procedures and requirements, that the part of the system to be operated on has actually been de-energized.

Once it has been verified that the voltage detection step has given a positive outcome and that the part of the system subject to intervention (e.g. a stall) is without voltage, it is proceed with grounding using special equipment.

Known grounding equipment comprises a plier that can be anchored to the conductor of a stall, a clamp that can be attached to an grounding mesh, and a conductive cable, which creates an electrical connection between the plier and the clamp.

To earth a stall, authorized personnel lift the plier using a rod, so as to anchor it to the conductor, and connect the clamp to the grounding handle.

The procedure above can therefore be summarized in the following operational steps:
1. identifying and delimiting the intervention area;
2. completely sectioning the affected part of the system;
3. ensuring against the re-closing of the sectioning devices;
4. checking that the system is off;
5. grounding and short-circuiting the disconnected active parts;
6. implementing protection measures towards any other adjacent active parts.

While the first three steps can be carried out through a series of interventions that do not require operators to get close to live parts, the verification of the presence/absence of voltage and the grounding and short-circuiting operation of the live parts requires instead the intervention of specialized personnel.

More specifically, in step 4 of the list above, the mobile rod described above is used, on the top of which a voltage detector device is positioned, in the form of an interchangeable head, designed and calibrated specifically for the voltage level of the plant in which the measurement is made. In particular, the detector devices are incorporated into the interchangeable heads, and the latter have a different shape due to the different electrical stresses to which they are subjected according to the voltage levels.

Based on the above, at present a technician is forced to use two distinct devices, the first for the detection, and the second for the grounding operations, in order to carry out the operations indicated.

In fact, once it is ensured that there is no voltage (see step 4 above) it is necessary to connect the part of the system with the earth circuit via a cop per cable (see step 5 above) using the aforementioned foil, different from that for voltage detection. The copper rope with its special connecting tip/clamp is hooked onto the top of the second foil.

In said step 5, in case that there is voltage on the part of the system to which the rope is being connected, there is an inevitable risk of electrocution by the operator who is carrying out the grounding.

It is therefore clear that the procedure explained in detail above is risky in terms of electrocution for the operators.

Relevant prior art includes patent application US2013/257414 A1. EP3567394 A1 discloses systems and methods for operating and calibrating measurement devices.

### Purpose of the invention

In light of the above, it is, therefore, the aim of the present invention to overcome the drawbacks and limitations of the prior art indicated above, so as to allow the detection of the line parameters and its subsequent grounding, limiting any electrocution risk.

It is also the aim of the present invention to propose a unique detector device both for the voltage level and for the type of system on which the measurement is carried out (station or line).

### Object of the invention

It is, therefore, specific object of the present invention a detection device for detecting the voltage and/or the current in an electrical system, such as a trellis, a power line, a power substation, a power mains, and the like, comprising a rod, having a proximal end and a distal end, and comprising detecting means for generating an electrical signal following the detection of the voltage and/or the current in an area of said electrical system, and at least one grounding head, which can be associated with said distal end of said rod, wherein said at least one grounding head is configured for grounding of said area of said system.

In this case, the same voltage detection device also carries the coupling means for the interchangeable heads, so that it can be used to ground the part of the system on which to operate.

Always according to the invention, said detecting means may detect a magnetic and/or electromagnetic field surrounding said rod.

Still according to the invention, said grounding head may comprise two hooks for handling grounding ropes, and/or a seat or a plier.

Advantageously according to the invention, said device may comprise a control unit, operatively connected to said detecting means, and configured for processing said signals, to signal the possible presence of voltage and/or current in said area of said system.

Further according to the invention, said device may have a housing, arranged at said distal end, and said control unit may be arranged in said housing.

According to the invention, said detecting means comprise sensors having a pair of capacitive plates arranged facing each other, installed in the body in said rod, and a magnetic sensor, installed in said rod.

According to the invention, the detection device comprises a control unit comprising a programmable microprocessor, and a test and calibration system, connected to said microprocessor, comprising a magnetic field generation unit for generating an electric signal, a magnetic injector, electrically connected to said magnetic field generation unit, wherein said magnetic injector is arranged in said rod close to said magnetic sensor, to generate a magnetic field proportional to said signal received from said magnetic field generating unit, a unit for generating an electromagnetic field, connected to said microprocessor to generate an electric signal, and further electromagnetic injectors, connected to said unit for generating an electromagnetic field, each arranged close to a respective capacitive plate, to generate an electromagnetic field, wherein said microprocessor controls said magnetic field generation unit and said unit for generating an electromagnetic field, to verify the operation respectively of said magnetic sensor and of said capacitive plates.

Still according to the invention, said device may comprise signaling means, such as a loudspeaker and/or optical indicators, which can be actuated when said control unit signals the possible passage of current in said area of said electrical system.

### Brief description of the figures

The present invention will be now described, for illustrative but not limitative purposes, according to its preferred embodiments, with particular reference to the figures of the enclosed drawings, wherein:
figure 1 shows a perspective view of a voltage detector device according to the present invention;
figure 2 shows an operator while applying the detector device to a system in a first use configuration;
figure 3 shows a detail of figure 2;
figure 4 shows an operator while applying the detector device to a system in a second configuration of use;
figure 5 shows a detail of figure 4; and
figure 6 shows a block diagram of the control unit of the voltage detector device according to the present invention.

### Detailed description

In the various figures the similar parts will be indicated with the same numerical references.

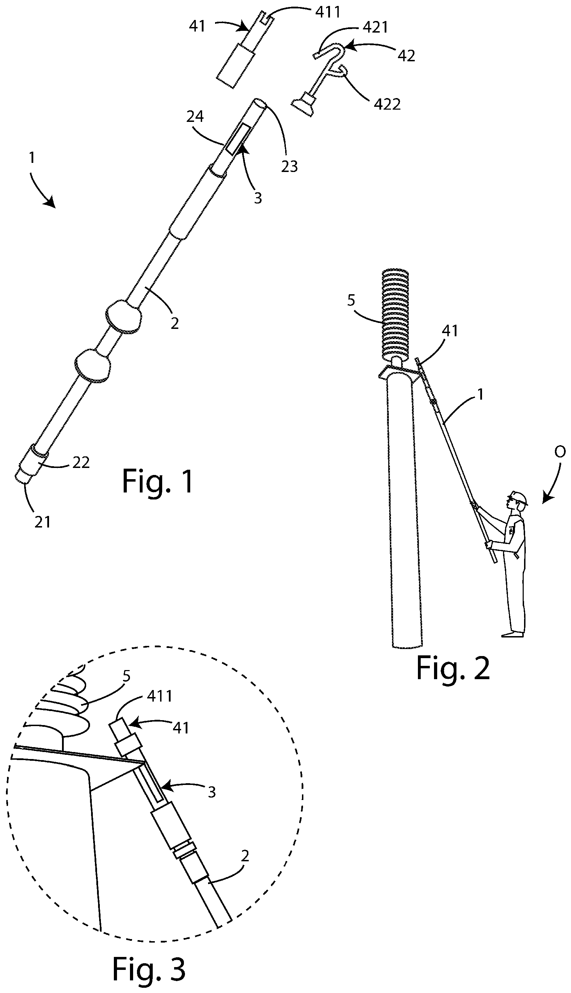

Referring to figure 1, a voltage detector device 1 according to the present invention is observed.

The detector device 1 comprises a rod 2, a control unit 3, and, alternatively, a first 41 and a second 42 grounding head, which can be associated with the rod 2, for grounding respectively in the station or in line.

The rod 2 of the device 1 has a proximal end 21, in which a handle 22 is provided for the manipulation of the device 1 by an operator, and a distal end 23, at which a housing 24 is provided.

The control unit 3, whose operation will be better defined below, is placed in said housing 24. In other embodiments, the housing 24 and the central control unit 3 can be positioned differently on the rod 2. Furthermore, the housing 24 and/or the central control unit 3 can also be removably coupled to the rod 2.

The first grounding head 41 has a seat or plier 411 to allow the grounding of the electrical system S to be maintained, or of an area thereof. The second detection head 42 also comprises two hooks 421 and 422, intended for grounding ropes of the type used for grounding electrical systems.

As can be seen, the detector device 1 incorporates, at the distal end 23 of the rod 2, the voltage detector device, so that it is possible to have a single detector device for the operations of verifying the presence/absence of voltage and for the grounding.

The operation of the detector device 1 described above is as follows.

Referring to figures 2-5, an operator O can be observed using the detector device 1 according to the invention in two different configurations.

In particular, in figures 2 and 3 there is the application of the first grounding head 41. In this case, the operator O, using the detection device 1, detects a possible magnetic and/or electromagnetic field caused by the passage of electrical current or by the presence of voltage. At the same time, the operator O can, by means of the grounding head 41, and in particular by means of the seat or plier 411, ground the area of interest of the electrical system S on which any maintenance operations must be carried out.

For example, in the event that there was current, and therefore an electromagnetic field was detected, there would be processing of the signal detected by the control unit 3, and the consequent generation of an acoustic or optical warning signal, aimed at warning the O operator.

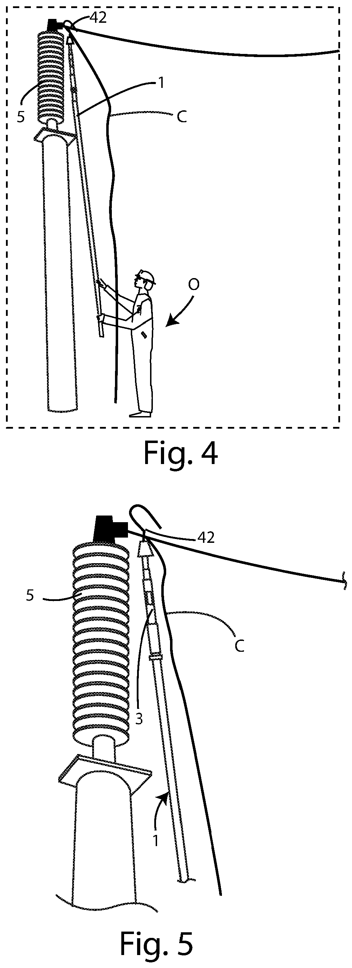

Instead, referring to figures 4 and 5, it is observed the detector device 1 equipped with the second detection head 42. In this case, the device always allows the magnetic and/or electromagnetic detection of signals or electromagnetic fields in the area of the electrical system S to be maintained, while with said second grounding head 42 it can, at the same time, manipulate the grounding ropes C by means of the hooks 421 and 422.

The first 41 and the second 42 grounding heads are interchangeable, depending on whether the grounding is carried out in the station or in line. In this way, as will be deepened in greater detail below, it is possible to detect the voltage even in the grounding step, increasing the safety of the operator O, who would be warned in advance in the event that there was voltage in the part of the electrical system S on which the grounding rope C must be applied for maintenance.

Generally, considerate is considered that since the proximity of the grounding rope C to the detector device 1 decreases its sensitivity, to compensate for it, two different detection technologies were applied at the same time, namely, as anticipated, both electromagnetic and magnetic.

In addition, the detector device 1 is equipped with filters having adjustable parameters (quality factor etc.), so as to maximize the amplification/sensitivity of the system, while maintaining a high immunity to disturbances of electrical signals having frequencies different from the frequency of network, which generally, as is known, is 50 or 60 Hz.

Electromagnetic detection technology is normally used by voltage detectors, which only detect the value (amplitude) and frequency of electromagnetic fields. Magnetic technology, on the other hand, allows the detection of even weak currents circulating in the component parts of the system.

In some embodiments, the detector device 1 comprises a microprocessor, which self-sets according to the configurations chosen in the initial setup step, so as to act on the values of the magnetic/electromagnetic fields by calculating, depending on their presence and amplitude, specific logical/mathematical factors, as well as diversifying the setting and action of the filters (as better explained below), in order to have the necessary voltage presence/absence data available in real time, i.e. with a minimal delay due to processing.

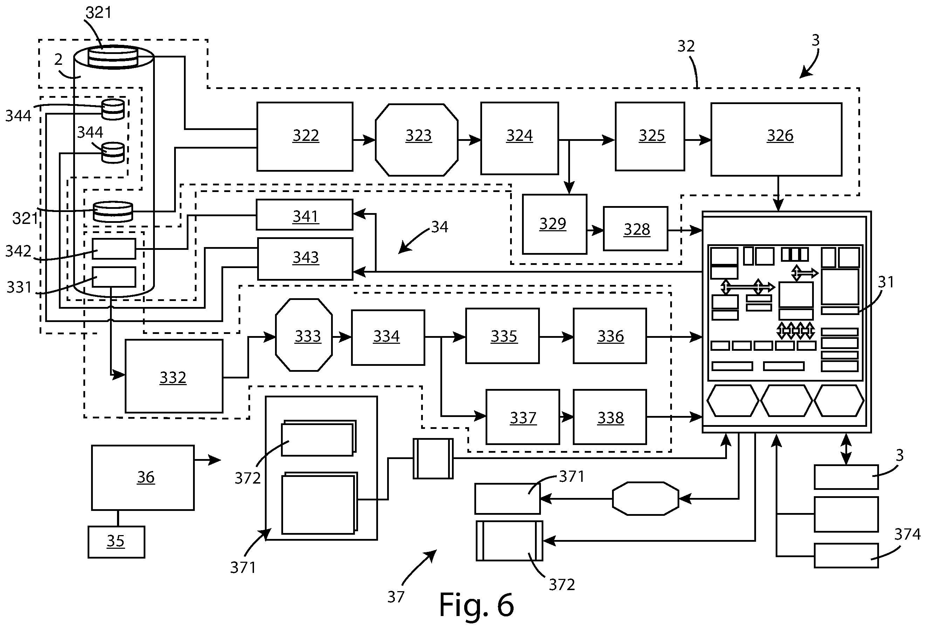

More specifically, referring to figure 6, it is observed the block diagram of the control unit 3 according to an embodiment, which mainly comprises a programmable microprocessor 31, connected to an electromagnetic field detection system 32, a field detection magnetic system 33, and a test and calibration system 34.

The electromagnetic field detection system 32 comprising, as electromagnetic sensor means, two capacitive plates 321 of circular shape and arranged facing each other, installed in the body of the rod 2. Said capacitive plates 321 are capable of detecting weak signals/fields electromagnetic forces of high voltage parts (e.g., plant uprights/lines).

These signals are amplified via a high input impedance differential amplifier 322. The amplification factor of the differential amplifier 322 is adjusted via the firmware inserted into said microprocessor 31. The signal thus amplified is filtered through an adjustable band pass filter, which consists of a band pass filter, for example at 50 Hz, but adjustable to the appropriate frequency (20-100Hz), which has an adjustable merit factor (i.e., the bandwidth).

Then, the filtered signal is amplified by a voltage-controlled amplifier 324 and is routed into two distinct branches.

In a first branch the signal is rectified via a bridge rectifier 325 and, subsequently, via the adjustable threshold envelope detector 326. The envelope of the electromagnetic signal is sent to the microprocessor 31.

In the second branch, the signal is subsequently filtered by an adjustable low-pass filter, which consists of a low-pass filter with an adjustable bandpass, and, subsequently, transformed by an analog/digital converter 328, which samples the signal at a frequency and a resolution (8/16/24/32 bit) set by the microprocessor 31, which also reads and processes the signals coming out of the low pass filter 326, and the analog/digital converter 328 (electromagnetic signal) by processing an FFT (Fast Fourier Transform) and to establish whether the detector device 1 is in the presence of an electromagnetic signal with a valid frequency, waveform and amplitude to interpret it as the presence of high voltage (AT).

According to the settings set, the microprocessor 31 warns the operator O, via optical and acoustic signals, both local and remote, if voltage is present in the part of the system on which s/he is working.

The magnetic field detection system 33, similarly to the electromagnetic field detection system 32, which detects the presence of electromagnetic fields, provides additional circuitry capable of detecting the presence of weak magnetic fields due to small currents circulating in the different parts of a system in which there is a certain voltage. These reduced currents are due to the various components of the electrical system S, which with their losses (eddy currents, etc.) create these modest current circulations.

The magnetic field detection system 33 comprises a magnetic sensor 331, which is a coil installed in the body of the rod 2 itself of the detector device 1. This magnetic sensor 331 is capable of detecting weak magnetic signals/fields of high voltage parts (AT), in which, due to the presence of voltage, even a very weak current could flow (e.g., in plant uprights /lines).

The magnetic field transformed into an electric signal by the magnetic sensor 331 is amplified via a low impedance amplifier 332. The amplification factor of said low impedance amplifier 332 is set and adjusted via the firmware in the microprocessor 31. The signal thus amplified is filtered through the adjustable bandpass filter 333, which consists of a bandpass filter, in the example illustrated here at 50 Hz but adjustable to the appropriate frequency (20-100Hz), which has an adjustable merit factor (bandpass).

Subsequently this signal is amplified by a voltage controlled amplifier 334, and is routed into two branches.

In a first branch the signal is rectified through a double bridge rectifier 335, and then through an envelope detector with adjustable threshold 336, in which the envelope of the electromagnetic signal is sent to the microprocessor 31.

In a second branch, the signal is subsequently sent to the adjustable low pass filter 337, which consists of a low pass filter with adjustable bandpass and subsequently to the analog/digital converter 338, which samples the signal with a frequency and a resolution (8- 32 bit) set by the microprocessor 31.

Said microprocessor 31 also reads and processes the signals coming out of the low pass filter 336 and said analogue/digital converter 338, processes the digital resultant (8/16/24/32 bit) of the magnetic signal thus sampled by processing an FFT (Fast Fourier Transform) and decodes whether the detector device 1 is in the presence of a magnetic signal (magnetic field) with a valid frequency, waveform and amplitude to interpret it as the presence of high voltage.

According to the set operating settings, the microprocessor 31 will warn the operator O, via optical and acoustic signals, both locally and remotely, if the part or area of the electrical system S on which he is operating is in the presence or absence of voltage.

The control unit 3 also comprises, if necessary, a test and calibration system 34. In particular, the microprocessor 31 can request a magnetic field generation unit 341 to generate an electrical signal which, applied to a magnetic injector 342, allows the generation of a magnetic field. The latter is arranged in said rod 2, close to said magnetic sensor 331.

The magnetic field generator unit 341 is configured to generate a magnetic field, by means of the magnetic injector 342.

Similarly, if necessary, the microprocessor 31, through the electromagnetic field generating unit 343, can generate an electrical signal to be applied to further electromagnetic injectors 344, each arranged in proximity to a respective capacitive plate 321. The further electromagnetic injectors 344 are suitable for generating an electromagnetic field, which will affect said capacitive plates 321.

In addition to the above, the detector device 1 is completely waterproof. For this purpose, in fact, to make the detector device 1 completely sealed tight, increasing its reliability, robustness and durability, instead of the traditional power button/switch, a reed device 35 with watertight electrical contacts in a mercury bath was used, i.e., a magnetic sensor, which can be remotely activated by bringing a key, in which a magnet is inserted near it (not shown in the figure).

When the magnetic key is brought close to the reed device 35, the latter will close its contacts and give the power-on command to the power supply block 36 with an auto power off system, which, via a signal sent to the microprocessor 31, will initially test all the detection systems, to prepare the detection device 1 according to the settings set for the voltage presence detections to be carried out, and finally to make the control unit 3 fully operational. After a settable time interval, the detection device 1 will turn off automatically, emitting audible and visual warning signals and, subsequently, after shutdown warning signals, before turning off, cutting off the power.

All warning signals, switching on, alarms, signals and various operations, switching off etc., both audible and visual, can be set as simple tones, synthesized phrases and flashes having all the possible characteristics which can always be set as desired via the settings (tone frequency, type of voice, language to use, phrase to recite, duration, volume, etc.).

All the signals and data with which the detection device 1 communicates with the external peripherals 37, i.e. the terminals 371, telephones/smartphones etc. have operating parameters that can be selected and customized via the system and the initial setting software.

This setting is accessed via terminal 37 equipped with an LCD display 372 and an alphanumeric keypad 373. Said terminal 371 can be connected to the detection device 1 via a fiber optic socket 374, Wi-Fi 375, Bluetooth 376, or similar. Through these interfaces, it is also possible to provide remote access to the settings.

In addition to the above, this detector device 1 has the characteristic of being programmable for all voltage levels (for example from 130 to 380kV) and works independently on stations and lines.

Finally, the control unit 3 also comprises signaling means 37, such as a speaker 371 and optical indicators 372, connected to said microprocessor 31. When the capacitive plates 321 and/or the magnetic sensor 331 detects an electromagnetic field, said microprocessor 31 activates said signaling means 37 to warn the operator O.

### Advantages

An advantage of the present invention is that it increases operator safety, thanks to the fact that the risk of possible exchanges of the uprights during detection and subsequent grounding is avoided.

The present invention has been described for illustrative but not limitative purposes, according to its preferred embodiments, but it is to be understood that modifications and/or changes can be introduced by those skilled in the art without departing from the relevant scope as defined in the enclosed claims.

## Claims

1. A detection device (1) for detecting the voltage and/or the current in an electrical system (S), such as a trellis, a power line, a power substation, a power mains, and the like, comprising
a rod (2),
having a proximal end (21) and a distal end (23), and
comprising detecting means (321, 331) for generating an electrical signal following the detection of the voltage and/or the current in an area of said electrical system (S), and
at least one grounding head (41, 42), which can be associated with said distal end (23) of said rod (2), wherein said at least one grounding head (41, 42) is configured for grounding of said area of said system (S),
wherein said detecting means comprise sensors having a pair of capacitive plates (321) arranged facing each other, installed in the body in said rod (2), and
a magnetic sensor (331), installed in said rod (2), the detection device (1) comprising a control unit (3) comprising
a programmable microprocessor (31), and
a test and calibration system (34), connected to said microprocessor (31), comprising
a magnetic field generation unit (341) for generating an electric signal,
a magnetic injector (342), electrically connected to said magnetic field generation unit (341), wherein said magnetic injector (342) is arranged in said rod (2) close to said magnetic sensor (331), to generate a magnetic field proportional to said signal received from said magnetic field generating unit (341),
a unit for generating an electromagnetic field (343), connected to said microprocessor (31) to generate an electric signal, and
further electromagnetic injectors (344), connected to said unit for generating an electromagnetic field (343), each arranged close to a respective capacitive plate (321), to generate an electromagnetic field,
wherein said microprocessor (31) controls said magnetic field generation unit (341) and said unit for generating an electromagnetic field (343), to verify the operation respectively of said magnetic sensor (331) and of said capacitive plates (321).

2. Device (1) according to the preceding claim, **characterized in that** said detecting means (321, 331) detect a magnetic and/or electromagnetic field surrounding said rod (2).

3. Device (1) according to any one of the preceding claims, **characterized in that** said grounding head (42) comprises two hooks (421, 422) for handling grounding ropes (C), and/or a seat or a plier (411).

4. Device (1) according to any one of the preceding claims, **characterized in that** the control unit (3) is operatively connected to said detecting means (321, 331), and configured for processing said signals, to signal the possible presence of voltage and/or current in said area of said system (S).

5. Device (1) according to the preceding claim, **characterized**
**in that** of presenting a housing (24), arranged at said distal end (23), and
**in that** said control unit (3) is arranged in said housing (24).

6. Device (1) according to any one of the preceding claims, when depending on claim 4, **characterized in that** it comprises signaling means (37), such as a loudspeaker (371) and/or optical indicators (372), which can be actuated when said control unit (3) signals the possible passage of current in said area of said electrical system (S).

## Patentansprüche

1. Erfassungsvorrichtung (1) zur Erfassung der Spannung und/oder des Stroms in einem elektrischen System (S), wie beispielsweise einem Gittermast, einer Stromleitung, einem Umspannwerk, einem Stromnetz und dergleichen, umfassend
eine Stange (2),
die ein proximales Ende (21) und ein distales Ende (23) aufweist und
Erfassungsmittel (321, 331) zum Erzeugen eines elektrischen Signals infolge der Erfassung der Spannung und/oder des Stroms in einem Bereich des elektrischen Systems (S) umfasst, und
mindestens einen Erdungskopf (41, 42), der dem distalen Ende (23) der Stange (2) zugeordnet werden kann, wobei der mindestens eine Erdungskopf (41, 42) zur Erdung des Bereichs des Systems (S) ausgebildet ist (S),
wobei die Erfassungsmittel Sensoren mit einem Paar einander gegenüberliegend angeordneter kapazitiver Platten (321), die im Körper der Stange (2) installiert sind, und
einen in der Stange (2) installierten Magnetsensor (331) umfassen,
wobei die Erfassungsvorrichtung (1) eine Steuereinheit (3) umfasst, umfassend
einen programmierbaren Mikroprozessor (31) und
ein Test- und Kalibriersystem (34), das mit dem Mikroprozessor (31) verbunden ist und umfasst
eine Magnetfelderzeugungseinheit (341) zum Erzeugen eines elektrischen Signals,
einen magnetischen Injektor (342), der elektrisch mit der Magnetfelderzeugungseinheit (341) verbunden ist, wobei der magnetische Injektor (342) in der Stange (2) nahe dem Magnetsensor (331) angeordnet ist, um ein Magnetfeld zu erzeugen, dass proportional zu dem von der Magnetfelderzeugungseinheit (341) empfangenen Signal ist,
eine Einheit zur Erzeugung eines elektromagnetischen Feldes (343), die mit dem Mikroprozessor (31) verbunden ist, um ein elektrisches Signal zu erzeugen, und
weitere elektromagnetische Injektoren (344), die mit der Einheit zur Erzeugung eines elektromagnetischen Feldes (343) verbunden sind und jeweils nahe einer jeweiligen kapazitiven Platte (321) angeordnet sind, um ein elektromagnetisches Feld zu erzeugen,
wobei der Mikroprozessor (31) die Magnetfelderzeugungseinheit (341) und die Einheit zur Erzeugung eines elektromagnetischen Feldes (343) steuert, um den Betrieb des Magnetsensors (331) beziehungsweise der kapazitiven Platten (321) zu überprüfen.

2. Vorrichtung (1) nach dem vorhergehenden Anspruch, **dadurch gekennzeichnet, dass** die Erfassungsmittel (321, 331) ein die Stange (2) umgebendes magnetisches und/oder elektromagnetisches Feld erfassen.

3. Vorrichtung (1) nach einem der vorhergehenden Ansprüche, **dadurch gekennzeichnet, dass** der Erdungskopf (42) zwei Haken (421, 422) zur Handhabung von Erdungsseilen (C) und/oder einen Sitz oder eine Zange (411) umfasst.

4. Vorrichtung (1) nach einem der vorhergehenden Ansprüche, **dadurch gekennzeichnet, dass** die Steuereinheit (3) mit den Erfassungsmitteln (321, 331) wirkverbunden und dazu ausgebildet ist, die Signale zu verarbeiten, um das mögliche Vorhandensein von Spannung und/oder Strom in dem Bereich des Systems (S) zu signalisieren.

5. Vorrichtung (1) nach dem vorhergehenden Anspruch, **dadurch gekennzeichnet**
**dass** sie ein Gehäuse (24) aufweist, das an dem distalen Ende (23) angeordnet ist, und
**dass** die Steuereinheit (3) in dem Gehäuse (24) angeordnet ist.

6. Vorrichtung (1) nach einem der vorhergehenden Ansprüche, soweit von Anspruch 4 abhängig, **dadurch gekennzeichnet, dass** sie Signalisierungsmittel (37), wie beispielsweise einen Lautsprecher (371) und/oder optische Anzeigen (372), umfasst, die betätigt werden können, wenn die Steuereinheit (3) den möglichen Stromfluss in dem Bereich des elektrischen Systems (S) signalisiert.

## Revendications

1. Un dispositif de détection (1) destiné à détecter la tension et/ou le courant dans un système électrique (S), tel qu'un treillis, une ligne d'alimentation, un poste d'alimentation, un réseau d'alimentation et analogues, comprenant
une tige (2),
ayant une extrémité proximale (21) et une extrémité distale (23), et
comprenant des moyens de détection (321, 331) destinés à générer un signal électrique à la suite de la détection de la tension et/ou du courant dans une zone dudit système électrique (S), et
au moins une tête de mise à la terre (41, 42), pouvant être associée à ladite extrémité distale (23) de ladite tige (2), dans lequel ladite au moins une tête de mise à la terre (41, 42) est configurée pour mettre à la terre ladite zone dudit système (S),
dans lequel lesdits moyens de détection comprennent des capteurs comportant une paire de plaques capacitives (321) disposées face à face, installées dans le corps de ladite tige (2), et
un capteur magnétique (331), installé dans ladite tige (2),
le dispositif de détection (1) comprenant une unité de commande (3) comprenant
un microprocesseur programmable (31), et
un système de test et d'étalonnage (34), connecté audit microprocesseur (31), comprenant
une unité de génération de champ magnétique (341) destinée à générer un signal électrique,
un injecteur magnétique (342), connecté électriquement à ladite unité de génération de champ magnétique (341), dans lequel ledit injecteur magnétique (342) est disposé dans ladite tige (2) à proximité dudit capteur magnétique (331), afin de générer un champ magnétique proportionnel audit signal reçu de ladite unité de génération de champ magnétique (341),
une unité pour générer un champ électromagnétique (343), connectée audit microprocesseur (31) afin de générer un signal électrique, et
des injecteurs électromagnétiques supplémentaires (344), connectés à ladite unité pour générer un champ électromagnétique (343), chacun étant disposé à proximité d'une plaque capacitive respective (321), afin de générer un champ électromagnétique,
dans lequel ledit microprocesseur (31) commande ladite unité de génération de champ magnétique (341) et ladite unité pour générer un champ électromagnétique (343), afin de vérifier le fonctionnement respectivement dudit capteur magnétique (331) et desdites plaques capacitives (321).

2. Dispositif (1) selon la revendication précédente, **caractérisé en ce que** lesdits moyens de détection (321, 331) détectent un champ magnétique et/ou électromagnétique entourant ladite tige (2).

3. Dispositif (1) selon l'une quelconque des revendications précédentes, **caractérisé en ce que** ladite tête de mise à la terre (42) comprend deux crochets (421, 422) destinés à manipuler des câbles de mise à la terre (C), et/ou un siège ou une pince (411).

4. Dispositif (1) selon l'une quelconque des revendications précédentes, **caractérisé en ce que** l'unité de commande (3) est connectée opérationnellement auxdits moyens de détection (321, 331), et configurée pour traiter lesdits signaux, afin de signaler la présence éventuelle de tension et/ou de courant dans ladite zone dudit système (S).

5. Dispositif (1) selon la revendication précédente, **caractérisé en ce qu'**il présente un logement (24), disposé au niveau de ladite extrémité distale (23), et **en ce que** ladite unité de commande (3) est disposée dans ledit logement (24).

6. Dispositif (1) selon l'une quelconque des revendications précédentes, lorsqu'il dépend de la revendication 4, **caractérisé en ce qu'**il comprend des moyens de signalisation (37), tels qu'un haut-parleur (371) et/ou des indicateurs optiques (372), pouvant être actionnés lorsque ladite unité de commande (3) signale le passage éventuel de courant dans ladite zone dudit système électrique (S).
